# EUROPEAN PATENT SPECIFICATION

(11) **EP 1 200 772 B1**
(45) Date of publication and mention of the grant of the patent: **12.12.2007**
(21) Application number: 00948548.3
(22) Date of filing: 29.06.2000
(51) Int. Cl.: F21S 2/00, F21V 23/06, F21V 21/088, F21Y 101/02

(54) **ILLUMINATION APPARATUS**
BELEUCHTUNGSVORRICHTUNG
APPAREIL D'ECLAIRAGE

(30) Priority: 21.07.1999 US 144920 P
(43) Date of publication of application: 02.05.2002
(73) Proprietor: Teledyne Lighting and Display Products, Inc., Los Angeles, CA 90066 (US)
(72) Inventor: PELKA, David, G., Los Angeles, CA 90045 (US); PARKYN, William, A., Lomita, CA 90717 (US); POPOVICH, Michael, J., Del Mar, CA 92014 (US); PELKA, Eric, D., Los Angeles, CA 90045 (US); POPOVICH, John M., Solana Beach, CA92075 (US)
(74) Representative: Sajda, Wolf E.
(86) International application number: PCT/US2000/018002
(87) International publication number: WO 2001/007828

(56) References cited:
- EP-A- 0 733 850
- WO-A-99/20937
- DE-A- 2 309 586
- DE-A- 4 237 107
- US-A- 5 438 495

## Description

### Field of the Invention

The present invention relates generally to the field of lighting devices, and more specifically to devices capable of a low profile which utilize point sources, such as light emitting diodes, for illumination.

In particular, the invention relates to an illumination apparatus as defined in the preamble of claim 1. Such an illumination apparatus is known, for example, from US-A-5 438 495.

### Description of the Related Art

Low profile lighting devices are useful in a variety of applications, such as decorative strip lighting or display panel illumination. One common form of strip fighting utilizes neon tubes. Neon tubes have the advantages of being lightweight and lending themselves to decorative lighting. Further, the light output from neon tubes is relatively diffuse and uniform in appearance. However, neon tubes are fragile, require high voltage, and generate significant radiofrequency (RF) interference, which must often be shielded at significant cost. Fluorescent lighting is likewise diffuse, but is generally limited to short lengths and typically includes unattractive electrical connections.

Display panel illumination is often accomplished by placing light sources behind the panel to illuminate it. A diffuser box containing a light source can generate output that is fairly uniform, so long as the light sources are sufficiently far away from the display panel. This makes such devices bulky, however. If the fight sources are too close to the panel, the illumination will no longer be uniform, and the sources will be seen as "hot spots." Thus there is a need for a compact lighting device that provides uniform output intensity.

The prior art according to US-A-5 438 495 discloses a light fitting which is preferably intended to be embedded in the surface of a runway and which includes a light source with a reflector as well as a limiting light opening in the field of light. In the conventional device, a mirror device is arranged for reflecting a part of the field of light back towards the reflector for sending this light through the light opening after further reflection. In the conventional device, an optical diverter is provided which covers only approximately half of the light source and which is offset to one side of the light source. Hence, the optical diverter is provided with an asymmetrical configuration.

### Summary of the invention

Accordingly, the object underlying the present application is to provide an illumination apparatus which has a compact configuration and which provides a uniform light output intensity.

According to the invention, this object is solved by an illumination apparatus as defined in claim 1. Advantageous further developments of the illumination apparatus according to the invention are indicated in the various sub-claims.

According to one aspect of the invention, an illumination apparatus includes a cavity having reflective surfaces and an output area, as well as at least one light source disposed in the cavity, wherein the light source includes a point source and an optical diverter having a flared reflecting surface. The apparatus further includes an optical conditioning element over the output area, with the optical conditioning element including at least a diffuser, for example, a translucent film or plastic sheet. In a preferred embodiment, the flared surface is curved, and may be cuspated. In one preferred embodiment, the point source comprises an LED. In a preferred embodiment, the cavity reflecting surfaces are diffusively reflective.

According to another aspect of the invention, an illumination apparatus comprises a housing that includes a cavity having reflective surfaces and an output aperture. The apparatus also includes an optical conditioning element across the output aperture, in which the conditioning element comprises at least one sheet having a plurality of pixels. The apparatus further includes at least one light source disposed within the cavity directly beneath the conditioning element, in which the (at least one) light source includes a point source spaced less than 3-1/2 inches from the sheet that illuminates the reflective surfaces such that the ratio of the luminance of adjacent pixels is between 0.95 and 1.05 and such that the ratio of the luminance of non-adjacent pixels is between 0.5 and 2.0, whereby the appearance of illumination at the sheet is substantially uniform. In a preferred embodiment, the optical conditioning element includes a diffuser sheet disposed below the prism sheet. In one preferred embodiment, the optical conditioning element includes a second prism sheet with orientation 90° from the first. In a preferred embodiment, the (at least one) light source includes a point source and a total internal reflection lens having a cuspated surface for reflecting light from the point source against the diffusive reflective surfaces.

According to another aspect of the invention, an illumination apparatus includes a cavity formed by reflective material, in which the cavity has an output area. An optical conditioning element is at the output area. The apparatus further includes a light source in the cavity, in which the light source includes a point source and an optical diverter having a reflecting surface which is partially reflective and partially transmissive. The reflective surface of the diverter allows a portion of light incident thereon to pass through the reflecting surface, while reflecting another portion of the incident light onto the reflective material of the cavity. The reflective material reflects light within the cavity, whereby the output area and the optical conditioning element are illuminated. In a preferred embodiment, the reflecting surface of the diverter is comprised of scattering centers which scatter light incident thereon.

According to yet another aspect of the invention, an illumination apparatus includes an optical diverter. The diverter includes transparent material having a reflecting surface formed by a refractive index interface configured to totally internally reflect light from a point source positioned to emit a first portion of fight rays towards the reflecting surface and a second portion of light rays towards a side surface of the diverter. The diverter includes a refracting interface that refracts the second portion of light rays towards the reflecting surface, such that both the first and second portions of light rays are reflected from the reflecting surface.

According to yet another aspect of the invention, there is provided an optical diverter that includes transparent material having a flared reflecting surface formed by a refractive index interface. The interface is configured to totally internally reflect light from a point source which is positioned adjacent to an apex of the flared reflecting surface and which emits light rays for reflection by the reflecting surface.

According to a further aspect of the invention, an illumination apparatus includes a cavity having reflective surfaces and an output area. The apparatus further includes at least one light source disposed in the cavity, in which the light source includes a point source and an optical diverter having a surface that is partially reflective and partially transmissive. The apparatus also includes an optical conditioning element over the output area, in which the optical conditioning element includes a diffuser, wherein the diverter is positioned between the point source and optical conditioning element such that (a) a portion of light emitted by the point source is reflected from the diverter towards the reflective surfaces of the cavity, and (b) another portion of light emitted by the point source is transmitted through the surface of the diverter towards the optical conditioning element, with the diverter sized to allow at least a substantial portion of the reflected light to reach the optical conditioning element without passing through the diverter, and wherein the diverter and the reflective surfaces of the cavity are arranged to allow at least a substantial portion of the transmitted light to reach the optical conditioning element without undergoing reflection.

### Brief Description of the Drawings

FIGURE 1 shows a first embodiment of a low profile lighting device with the housing partially cut away to reveal one of the point light sources and optical diverters therein.
FIGURE 2 is an exploded view of the embodiment illustrated in FIGURE 1.
FIGURE 3 shows another embodiment of a low profile lighting device.
FIGURE 4 is an exploded view of the embodiment illustrated in FIGURE 3.
FIGURES 5A and 5B are end and plan views, respectively, of a mounting channel having a slot for mounting the embodiment of FIGURES 1-2 or FIGURES 3-4 to the mounting bracket of FIGURES 6A and 6B.
FIGURES 6A and 6B are elevation and plan views, respectively, of a mounting bracket which is secured to a mechanical structure such as a building, and which receives the mounting channel of FIGURES 5A and 5B to mount the low profile lighting device on the building.
FIGURES 7A and 7B show a collar for mechanically and electrically coupling two lighting devices.
FIGURE 7C shows an electrical arrangement for coupling power to an end of a lighting device.
FIGURE 8 shows an optical diverter which utilizes total internal reflection for laterally diverting light from a light emitting diode or other point source.
FIGURES 9, 10, and 11 show the progression of light rays through the optical diverter of FIGURE 8.
FIGURE 12 shows an optical diverter which produces highly collimated "equatorial" output beam.
FIGURE 13 shows the progression of light rays through an optical diverter having scattering centers on its top surface for diffusely transmitting some light through the top surface.
FIGURE 14 shows an optical diverter having a roughened surface pattern in the form of a series concentric rings on its top surface for diffusely transmitting some light through the top surface.
FIGURE 15 shows an embodiment of a lighting device in the form of an alphanumeric character.

### Detailed Description of the Preferred Embodiments

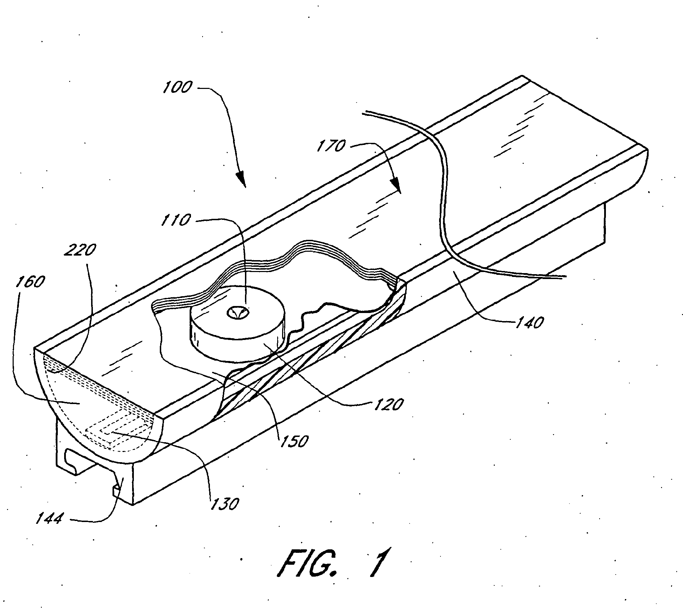

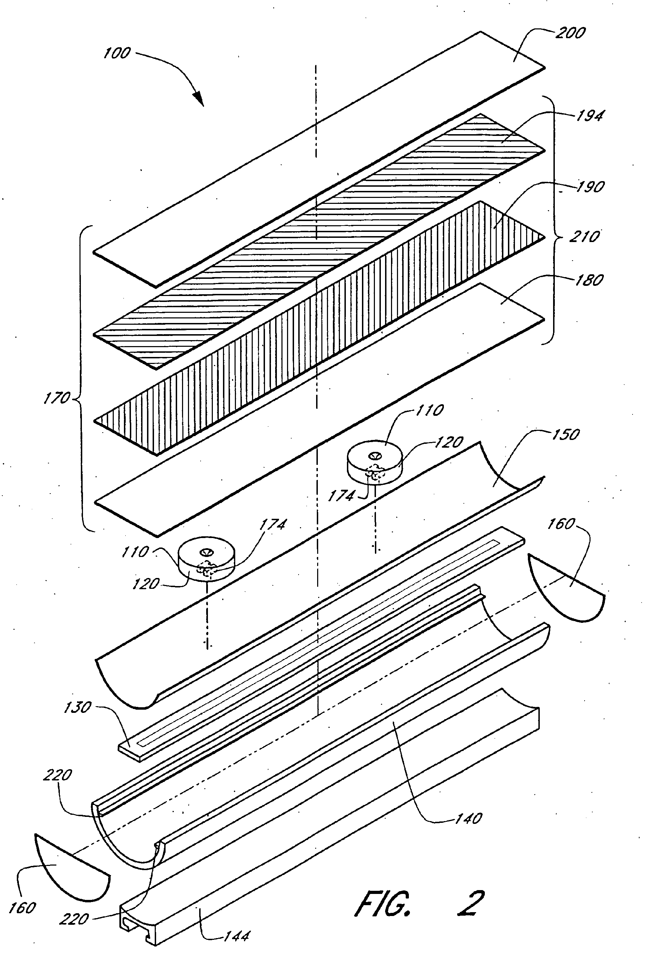

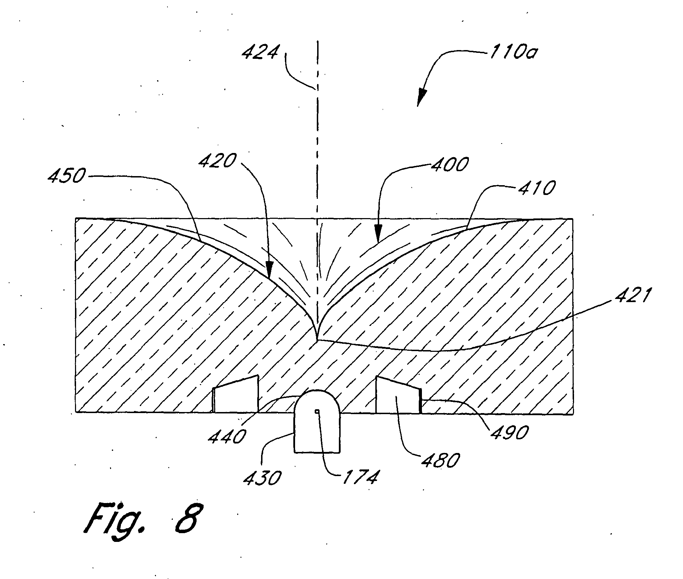

One preferred embodiment of a lighting device 100, illustrated in FIGURE 1, comprises plural light sources, each of which includes a point source such as a light emitting diode (LED) 174 shown in FIGURE 8, and an optical diverter 110. Light from the LED 174 is received by the optical diverter 110, which redirects the light laterally and downwardly. The plural LEDs are coupled to each other electrically by a printed circuit board 130 (a wire harness is an alternative configuration). The point sources 174 and optical diverters 110 are mounted within an elongate cavity formed by a sheet 150 of diffusively reflective material in the general form of a half or hemi cylinder. The sheet 150 is mounted in, and extends the length of, a housing 140, which may be an extrusion. The housing 140 is generally elongate and has a width that is not substantially greater than the width of the light output area. The printed circuit board 130 is disposed between the sheet 150 and the bottom of the housing 140. Wires (not shown) pass through the sheet 150 to electrically connect the point sources to the circuit board. A mounting channel 144 may be included on the bottom of the housing 140 for mounting the device 100 to a building. The mounting channel 144 may, for example, be made of acrylic that is bonded or glued to the housing 140, or the channel 144 may be integrally formed with the housing 140 as part of an extrusion process. The light that exits the diverters 110 is reflected by the diffusely reflecting sheet 150, located between the optical diverters 110 and the circuit board 130, as well as by diffusely reflecting end caps 160 connected to the housing 140 at either end of the device 100. If a plurality of optical diverters 110 are linearly arranged along the longitudinal axis of the cavity, the maximum separation between adjacent optical diverters 110 is preferably about twice the width of the device 100. Further, the optical diverters 110 are preferably separated by at least 0.5 inches.

The surfaces of the diffusely reflecting sheet 150 and the diffusely reflecting end caps 160 are preferably matte white, with diffuse reflectivity over 90%, preferably 96% or more. For this purpose, the sheet 150 and the caps 160 may be coated with diffusely reflective tape, such as DRP^{™} Backlight Reflector (W.L Gore & Associates), white paint, or more exotic materials such as Labsphere Corporation's Spectraflect paint. The reflectivity of Spectraflect paint is 98%, which is considerably higher than the reflectivity of house paint, which is approximately 92%. DRP^{™} Backlight Reflector has a reflectivity of approximately 97%-99.5%. Alternatively, the diffusely reflecting sheet 150 and the diffusely reflecting caps 160 may be constructed from a diffusely (or specularly) reflecting material, such as titanium dioxide, pigmented Lexan^{™} polycarbonate, or Spectralon^{™} plastic, thereby avoiding the need to apply a separate coating to the sheet 150 and the end caps 160. The reflectivity of Spectralon^{™} plastic is about 99%. Although it is preferred that the reflective surfaces 150, 160 be diffusively reflective, in an alternative embodiment these surfaces comprise specularly reflecting surfaces that are preferably faceted as in a product sold by 3M under the name Visible Mirror Film (specular or diffuse). Additionally, while the cavity of the preferred embodiment is gas-filled (with air), the cavity may also be formed by a liquid or solid.

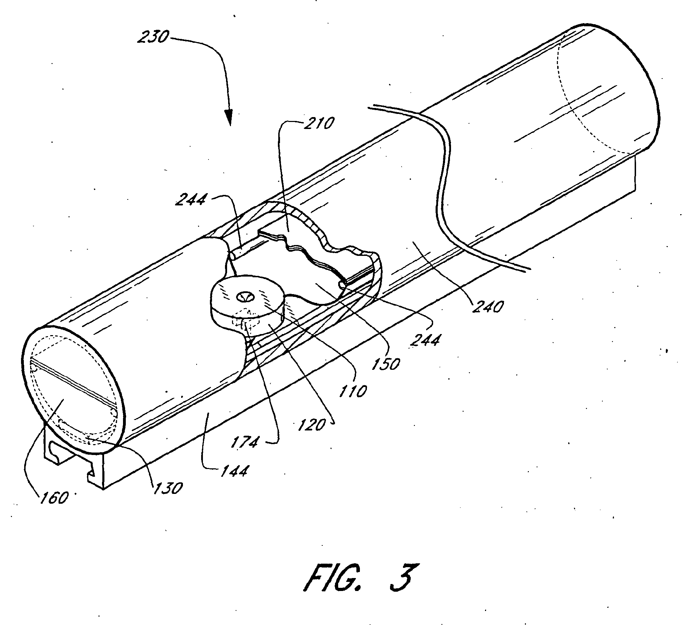

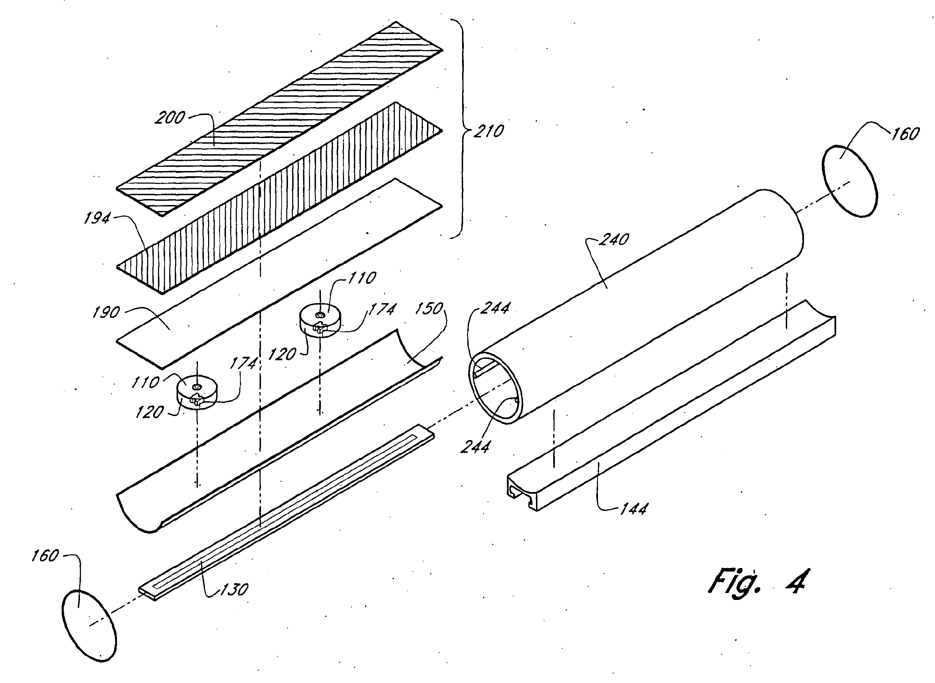

Light exits the device 100 through a sheet member or film stack 170, which faces the diffusely reflecting sheet 150. As shown in FIGURE 2, the sheet member 170 acts as the output face of the device 100, and comprises an optical conditioning element 210, which may be covered with transmissive outer protective cover 200. The optical conditioning element 210 includes fin the direction of light propagating outward through the sheet member 170) one or more sheets of material, which are substantially parallel to each other, namely, a diffuser 180, an optional first prism sheet 190, and an optional second prism sheet 194. The diffuser 180 acts to randomize the direction of the light incident upon it and preferably has relatively low backscattering. By way of example, the diffuser 180 may be of any construction that will diffuse light, such as translucent sheets of plastic, or plastic with a rough surface. The prism sheets 190 and 194 may each be a brightness-enhancing film (BEF) for reducing the solid angle of the light, with an angular emission in the range of 50 to 80 degrees full width half maximum (FWHM). Brightness-enhancing films suitable for use in the preferred embodiments are commercially available from 3M Corporation. A thin film BEF, having linear pyramidal structures therein, is described in U.S. Patent 5,684,354 to Gleckman, which is hereby incorporated by reference herein. Preferably, the repeated structures of the sheets 190 and 194 are crossed at generally 90 degrees with respect to each other, and are each oriented at 45 degrees with respect to the longitudinal axis of the elongate housing 140.

The diffuser 180 and the prism sheets 190 and 194 of the optical conditioning element 210 spread the light uniformly over the output face of the device 100, The prism sheets also serve to concentrate the optical energy within a field of view, and this causes the light to be directed more intensely in the direction of an observer within that field. While it is preferred that the diffuser 180 be placed below the prism sheets 190 and 194 (as shown in FIGURE 2), it will be understood that the position of the diffuser and the prism sheets may be exchanged. The optical conditioning element 210 and the point source 174 are preferably separated by less than 3.5 inches, more preferably by less than 2.5 inches, and still more preferably by less than 1.5 inches. The protective outer cover 200 protects the device 100 from the environment, and may act as a color filter or contain darkened or lightened regions of a specific pattern, such as a logo, design, or alphanumeric characters.

As shown in FIGURE 2, the point sources 174, such as LEDs, are disposed just beneath the optical diverters 110. Electrical leads (not shown) from the point sources 174 are connected to the printed circuit board 130, with the sheet 150 having holes punched therein for accepting the leads of the LEDs 174, such that the sheet is positioned between the LEDs and the printed circuit board. The housing 140 includes lips or flanges 220 for holding the diffusely reflecting sheet 150 in place. The sheet 150 (and the LEDs 174 and the printed circuit board 130 to which the sheet 150 is attached) is advantageously flexible so that it may be slid underneath the lips 220, permitting the sheet 150 to naturally assume a shape which is typically parabolic in cross section. When the sheet 150 assumes a parabolic cross section, light reflected off the sheet is efficiently directed towards the optical conditioner 210.

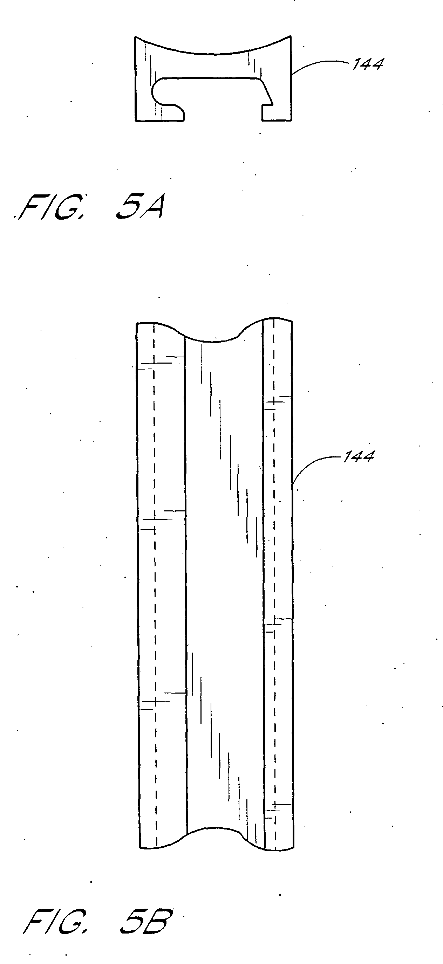

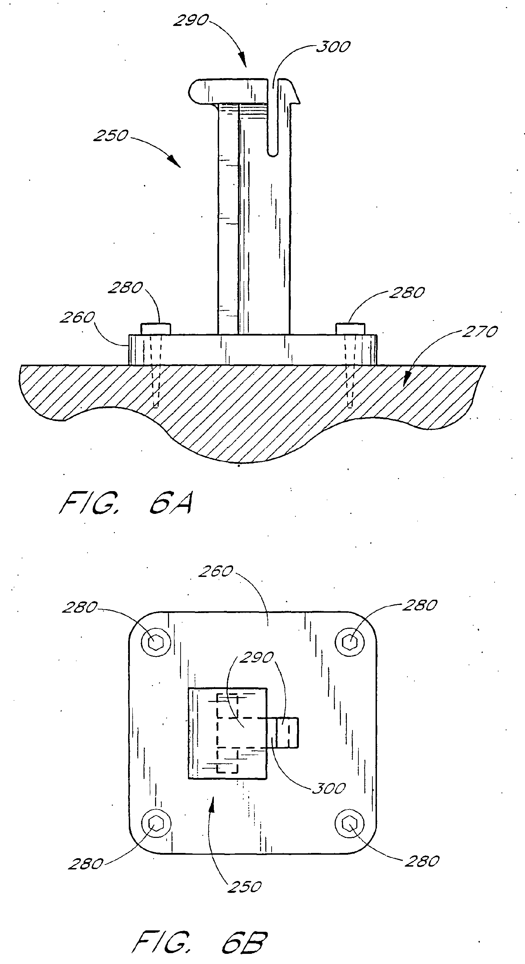

An alternative preferred embodiment is illustrated in FIGURES 3 and 4. In this embodiment, a device 230 includes a cylindrically shaped housing 240 that functions both as a housing and a protective outer cover. The sheet member 170 is secured to a pair of lips or flanges 244 that run along the length of the device 230. (The flanges 244 may also function the same as the lips 220 of FIGURE 2, for holding the reflecting sheet 150 in place.) The device 230 is otherwise substantially similar to its counterpart 100 of FIGURES 1-2, and similar parts are designated with the same reference numerals. The housing 240 may be colored or include darkened portions for producing a desired visual effect. Alternatively, separate elements or layers of film (not shown) disposed between the conditioning element 170 and the housing 240 may be used for achieving a desired optical effect. Such elements may also be used in conjunction with the embodiment shown in FIGURES 1 and 2.

One aspect of the embodiments shown in FIGURES 1-2 and FIGURES 3-4 is that the intensity of light exiting the optical conditioning element 210 is spatially very uniform and thus appears to an observer to have constant luminance across the entire element 210. This uniformity can be quantified with reference to an imaginary grid of 1 mm² "pixels" on the output side of the optical conditioning element 210. As used herein, the term "pixel" means any square millimeter cell defined by an imaginary grid on the output side of the element 210 formed by two orthogonal sets of parallel lines separated by 1 mm. Thus, a pixel as used herein does not represent a discrete element, but rather corresponds to a square millimeter of the exterior surface of element 210. The ratio of the luminance of adjacent pixels is preferably between 0.95 and 1.05, more preferably between 0.98 and 1.02, and still more preferably between 0.99 and 1.01. The ratio of the luminance of non-adjacent pixels is preferably between 0.5 and 2.0, more preferably between 0.57 and 1.75, still more preferably between 0.67 and 1.5, and most preferably between 0.77 and 1.3. It will be understood that a given ratio can be more or less than 1.0, depending upon whether the ratio is determined with the intensity of the more intense pixel placed in the numerator or the denominator, respectively.

As illustrated in FIGURES 5A and 5B, the mounting channel 144 is configured to mate with a mounting bracket 250, such as that illustrated in FIGURES 6A and 6B. The mounting bracket 250 is attached to a plate 260 that may be fastened to a building 270 or other structure using screws 280, bolts or the like. The mounting bracket 250 may be made of compliant plastic (or another suitable, outdoor-rated material) and comprises a latching member 290. To secure the mounting bracket 250 to the mounting channel 144, the profile of the latching member 290 is reduced by pressing the latching member 290 into the mounting channel 144, thereby squeezing both sides of the latching member about a slot 300, so that the latching member 290 is received by the mounting channel 144. Once the latching member 290 is within the channel 144, it springs back to reassume its uncompressed state (FIGURE 6A), thereby holding the lighting device 100 (230) in place.

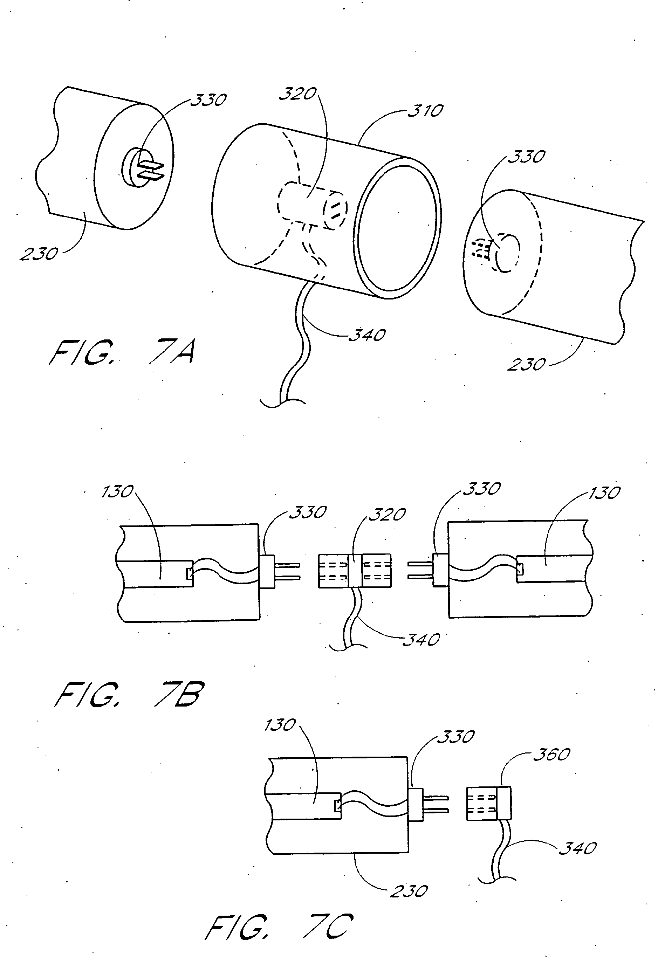

The lighting devices 230 (100) may be advantageously constructed in segments of various lengths, such as 2, 4, or 8 feet. Two or more segments may be coupled together by a collar 310 as illustrated in FIGURES 7A and 7B. Within the collar 310 is a dual female connector 320 for receiving respective male connectors 330 from each of two lighting devices 230. The male connectors 330 are electrically connected to the printed circuit board 130, and the female connector 320 is tied electrically to a power source via an electrical line 340. The female connector 320 may be held in place within the collar 310 by, for example, rings or spokes (not shown) that extend within the collar. FIGURE 7C shows an alternative arrangement in which power is supplied via a single female connector 360 located at one end of one of the devices 230. In this case, adjacent devices 230 may be connected by a dual female connector (not shown) to which no electrical line 340 is attached.

A preferred embodiment of the optical diverter 110 is illustrated with respect to FIGURES 8-11. FIGURE 8 shows a cross section of an optical diverter 110a which includes a total internal reflection (TIR) region 400 with a surface 410 that is smoothly curved and defines a vortex shape forming an apex 421 that extends into the optical diverter 110a. The optical diverter 110a is surrounded by air, so that a refractive index interface is formed, which permits total internal reflection. The surface 410 of this embodiment substantially completely reflects light incident thereon, such that substantially no light is transmitted therethrough. The TIR region 400 may advantageously have the shape of an equiangular spiral that forms a cuspate portion 420. The surface 410 of FIGURE 8 is shown as being axially and circularly symmetrical and extending 360 degrees about a vertical axis 424 aligned with and passing through the point source 174. However, a TIR diverter (not shown) may be used in which the cuspate portion is symmetrical about a line rather than being symmetrically oriented about a point, as in FIGURE 8. Such a TIR diverter enjoys planar rather than radial symmetry.

In the embodiment of FIGURE 8, the point source 174, such as an LED, is mounted below the apex 421 of the TIR surface (i.e., just below the point on the cusp 420) in close proximity thereto, with the reflecting surface extending 360° about the LED and apex. The LED 174 is contained within an LED package 430. which resides within a recess 440 in the optical diverter 110a. In order to ensure good coupling into the optical diverters 110 disclosed herein, and to reduce reflections at the interface between the LED package 430 and the boundary of the recess 440, a transparent optical coupling agent (not shown), such as an adhesive or gel, may be used to preclude any optically interfering air gaps between the LED 174 and the optical diverter. The transparent optical coupling agent could be an epoxy, silicone, or any well-known organic or inorganic optical coupling material. Preferably, the refractive index of the coupling agent is between that of the LED package and the optical diverter 110.

The surface 410 may be curved, or it may include a plurality of flat surfaces approximating a curve to form a totally internally reflecting (TIR) lens having a focal point. When the point source 174 is positioned (as shown) at this focal point, light generated by the point source 174 is totally internally reflected from the surface 410. If the surface 410 is curved, any one of a number of shapes may be employed, such as a hyperboloid, paraboloid, cone, cusp or other surface of revolution. Mathematical modeling of these shapes can be performed with an optical analysis software package such as ASAP by Breault Research of Tucson, Arizona. The surface 410 is contoured such that substantially all light rays emitted from the LED 174 at the focal point of surface 410 are incident on the surface 410 at an angle at least equal to the critical angle. This may be accomplished by calculating the range of possible incidence angles of light rays from the LED 174 at the focal point at various local portions of the surface 410. The local portions are then oriented so that all rays are incident within the critical range. The local portions could be large in size so that the surface 410 consists of a collection of flat surfaces, for example. As the size of the local portion decreases, the surface 410 forms into a smoothly curved surface having, for example, the equiangular spiral shape shown in FIGURE 8.

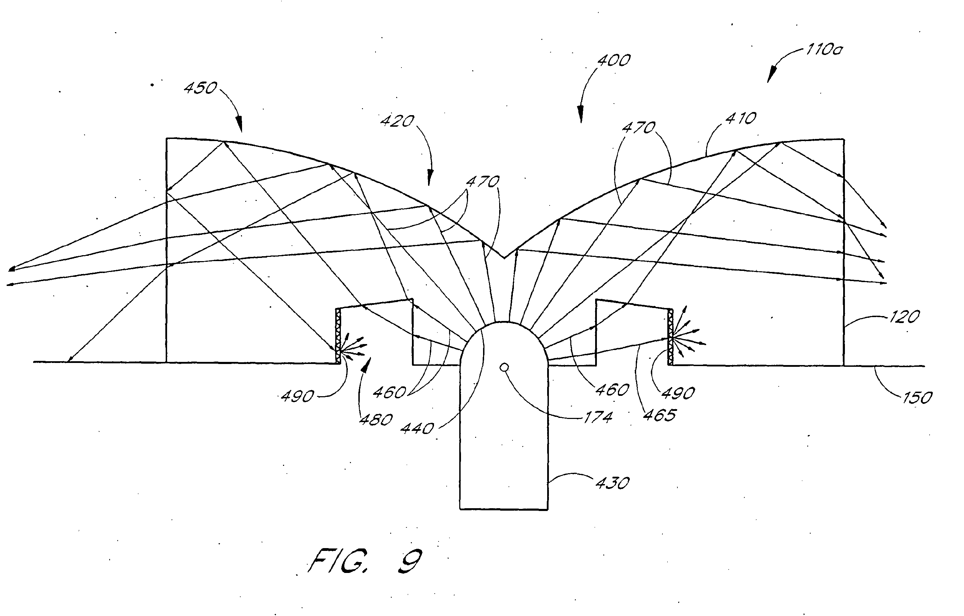

While a circularly and axially symmetric cuspated surface is preferred for many applications, the surface 410 need not be symmetrical. In general, the surface 410 is flared so that-light that reflects off of the surface 410 will be directed out of and away from the optical diverter 110a. In this sense, the optical diverter 110a of this embodiment acts as a lateral diverter of light. This flared surface 410 may be viewed as extending between an apex portion of the surface 410 (corresponding to the cusp 420 of FIGURE 8) and a base portion 450 above the apex. The base portion 450 flares outwardly (radially) from the vertical axis 424 that passes through the apex 421 and the point source 174. Thus, the flared reflecting surface 410 flares outwardly from the apex 421 to the base portion 450. A groove 480 in the embodiment of FIGURE 8 (and the embodiments of FIGURES 9, 10, 11 and 13 discussed below) has a depth such that substantially all rays which would otherwise propagate directly from the point source 174 to the side surface 120 of the diverter 110a are intercepted by at least one wall of the groove. Thus, the groove 480 prevents direct propagation of rays though the side surface 120 and onto the optical conditioning element 210, and thereby prevents such rays from causing non-uniformities in the output luminance.

FIGURES 9-11 depict the optical paths of various rays within the optical diverter 110a, in which FIGURE 9 is an overview of the various paths that light rays take. The optical diverter 110a is illustrated as having an annular groove 480, one face of which (surface 490) is frosted. The groove 480 redirects light from the LED 174 that is incident thereon. Light rays emanate from the LED 174 at the focal point of surface 410 within the LED package 430. Some light rays 460 are refracted through the inner side surface of the grove 480 for propagation to the top surface of the groove, where the rays 460 are again refracted for propagation to the TIR reflecting surface 410. Other rays 470 pass within the region bounded by the inner side surfaces of the groove 480, and thus by-pass the groove for direct propagation to the TIR reflecting surface. Rays 460 and 470 both undergo TIR at surface 410, are reflected downwards, and eventually exit the diverter through side surface 120. As discussed above in connection with FIGURE 1, light exiting the diverter 110a is diffusely reflected by the sheet 150 and by the end caps 160 at either end of the device 100 (230), and eventually exits the device through the sheet member 170, which faces the diffusely reflecting sheet 150.

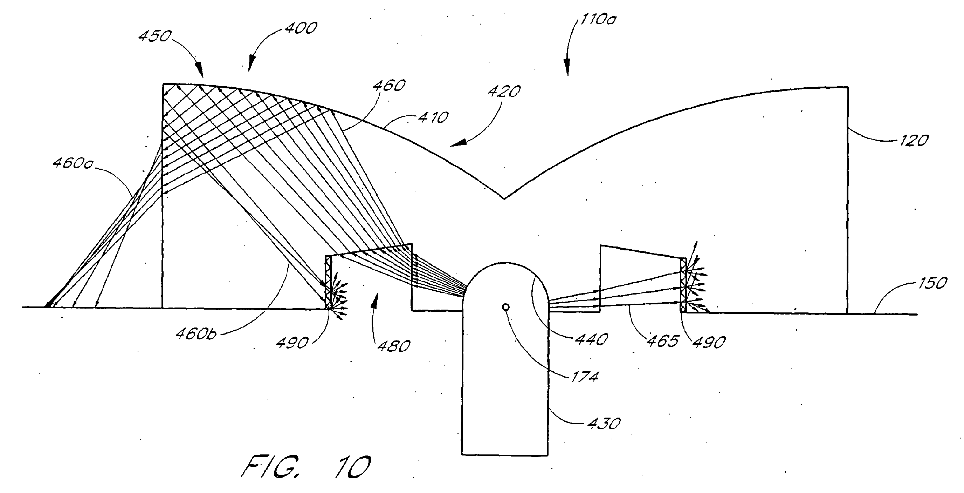

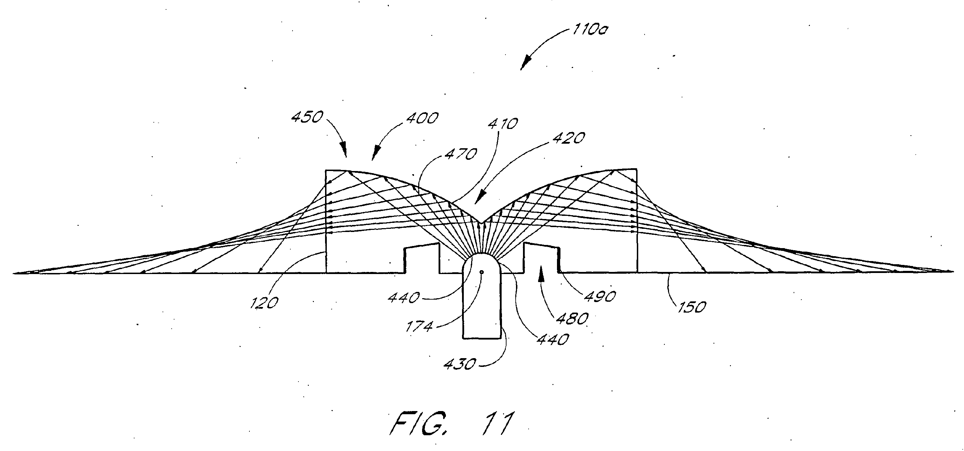

The progress of light rays 460 and 470 though the diverter 110a is shown in more detail in FIGURES 10 and 11, respectively. FIGURE 10 shows light rays 460 being refracted by the walls of the groove 480. While some rays 460a pass directly out of the side surface 120 of the diverter 110a after undergoing TIR, other rays 460b are internally reflected towards the frosted surface 490, where they are scattered in many directions before exiting the device 100 (230). FIGURE 10 also shows rays 465, which pass through the inner side surface of the groove 480 for propagation to the frosted outer side surface 490, where the rays 465 are scattered in many directions. This scattering prevents them from becoming visible through the output area. FIGURE 11 shows light rays 470 undergoing TIR at surface 410 and being refracted at face 120, whereupon the rays 470 exit the diverter 110a. Surface 410 can have a shape tailored to cause uniform illumination of the sheet 150.

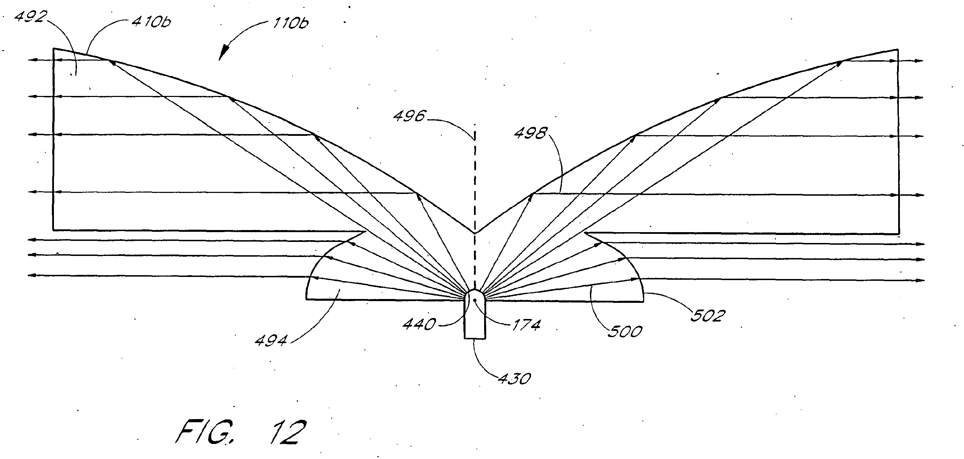

Another TIR embodiment is illustrated in FIGURE 12, in which an optical diverter 110b includes a flared reflecting surface formed by a cuspate portion 492 and a refracting portion formed by an elliptical drum lens or torus portion 494, below the cuspate portion 492. Both the cuspate portion 492 and the refracting portion 494 are surfaces of revolution about an axis 496 that passes through the point source 174, as well as through the apex of the cuspate portion 492. Light rays 498 that strike surface 410b in the cuspate portion 492 undergo total internal reflection and exit the diverter 110b propagating nominally perpendicular to the axis 496. Light rays 500 exiting a surface 502 of the toroidal portion 494 are refracted so that they also propagate nominally perpendicular to the axis 496. Further, the surface 502 is designed so that substantially no rays propagate from the point source 174 through the side surface 120N without first undergoing TIR at surface 410b. The resultant distribution of light outside of the diverter 110b is such that the embodiment of FIGURE 12 acts with an isotropic hemispheric source to produce an equatorial distribution with a latitudinal beam width depending on the relative size of the point source 174. The diverter 110b is suitable for use in the lighting devices disclosed herein, but alternatively, it may be used by itself outside of a housing 140 (240) to produce 360 degree, latitudinally narrow output in the far field. Typical applications are aircraft warning beacons for high structures and marine beacon on buoys.

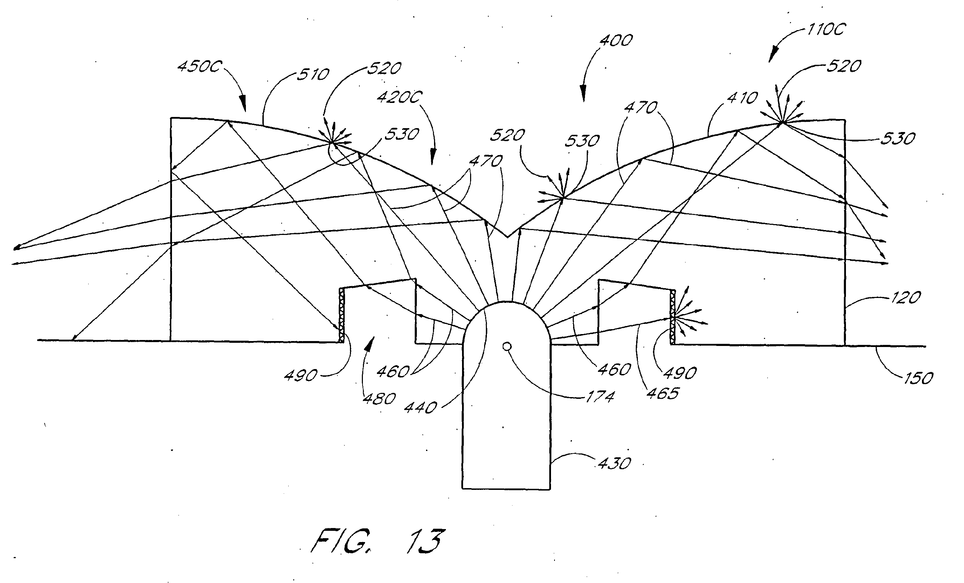

Although the embodiment illustrated in FIGURES 8-11 includes a surface 410 that is totally internally reflecting with respect to light rays 460 and 470, and the embodiment of FIGURE 12 also includes a surface 410b that is totally internally reflecting, an alternate embodiment comprises a surface 510 which is only partially rather than totally internally reflecting. As illustrated in FIGURE 13, this embodiment includes a flared surface comprising a cuspate portion 420c and a base portion 450c. Optical radiation 520 that would otherwise be reflected for propagation through the side face 120 of the optical diverter 110c passes through (i.e., is diffusely transmitted by) the surface 510 for propagation directly through the sheet member 170, without reflecting off the reflective sheet 150 or one of the caps 160. This may enhance uniformity of illumination of the sheet member 170 and eliminate optical losses associated with reflections off the sheet 150 and the caps 160. In FIGURE 13, however, a substantial portion of the light rays 460 and 470 are preferably still totally internally reflected at surface 510. The optical diverter 110c may be advantageously sized to allow at least a substantial portion of the light reflected off the cavity sheet 150 to reach the optical conditioning element 210 without passing through the diverter 110c, and the reflective surfaces 150 and 160 arranged to allow at least a substantial portion of the light transmitted through the surface 510 to reach the optical conditioning element without reflection. This feature acts to compensate for reduced illumination of the sheet 150 just beneath the diverter 110c.

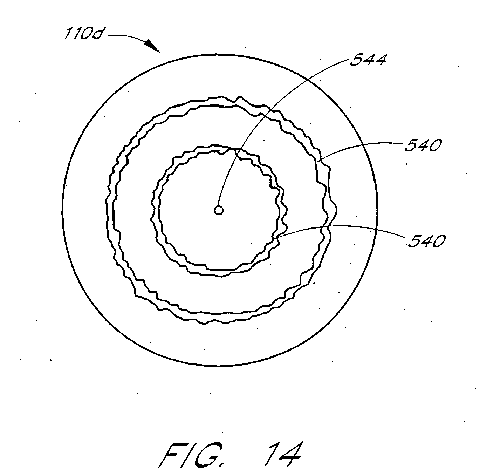

A surface 510 that is partially reflecting and partially transmitting may, in general, be formed by appropriately selecting the angle of incidence between the light rays 460 (470) and the surface 190. For example, the surface 510 may be formed at an angle that insures that some light "leaks through" the surface 190 while other light is reflected off of surface 190. Additionally, the apex of the cuspated portion may be rounded to provide controlled leakage of light from the LED 174 through the surface 510 immediately above the LED. This eliminates dark spots above the LED 174. Moreover, as illustrated in FIGURE 13, a surface 410 that is initially totally internally reflecting may be lightly sandblasted or etched to form distributed scattering centers 530 thereon, such that some of the light incident on the scattering centers passes through the surface 410. These scattering centers 530 may be distributed non-uniformly on the surface 410. Also, the surface 410 may be heavily etched or sandblasted to form a pattern such as a series of concentric rings 540 (see the diverter 110d of FIGURE 14) about a center 544 at an apex of the surface, which likewise results in some of the light leaking through the surface.

The optical diverters shown in FIGURES 8-14 may be comprised of material that is transparent to the light produced by the LED 174, such as a transparent polymeric material, and may be manufactured by various well-known methods, such as machining or injection molding. Preferred materials for the optical diverters 110 are acrylic, polycarbonate, and silicone. Acrylic, which has an index of refraction of approximately 1.5, is scratch-resistant and has a lower cost relative to polycarbonate. On the other hand, polycarbonate, which has an index of refraction of approximately 1.59, has higher temperature capabilities than acrylic. Polycarbonate also has improved mechanical capabilities over acrylic. Silicone has a refractive index of approximately 1.43. The refractive index of air is nearly 1.0.

While the reflectors of the preferred embodiments are flared, another embodiment (not shown) utilizes a non-flared planar reflector which is partially reflective and partially transmissive. Also, instead of using optical diverters 110 which rely upon total or partial internal reflection, reflection may be provided by partially or totally reflective mirrors (not shown), in which the mirrors are preferably contoured to reflect light laterally. Such mirrors may advantageously include a curved surface, so that light is reflected over a range of angles and scattered within the device 100 (230) to provide uniform illumination of the sheet member 170. This function may also be performed by a transparent optical element that has a non-uniform change in its index of refraction, for example, a gradient index optical element.

The point sources 174 may advantageously comprise an LED cluster that provides tricolor output, e.g., red, green, and blue, so that virtually any color may be produced by appropriately selecting the relative intensity of the respective component wavelengths. Further, both gradual and fast time-changes in color are possible, and travelling wave patterns may be generated when the respective outputs of the LEDs 174 are successively varied in a coordinated fashion. Although the point sources 174 have been principally described with respect to LEDs, other point sources may be used, such as miniature incandescent filaments or arc lamps (not shown). However, LEDs are preferred because of their ability to operate at relatively low voltage (e.g., 24 volts DC or less). Also, LEDs generate no RF interference. As a further alternative to using LEDs as the point sources 174, a fiber optic line (not shown) may be used to distribute light to a series of optical diverters 110, in which light is tapped off at various points along the fiber optic line (corresponding to the point sources 174) and is directed into the diverters. In this case, a laser diode or other light generator may be used to couple light into the fiber optic line, and the fibers form the point sources of light.

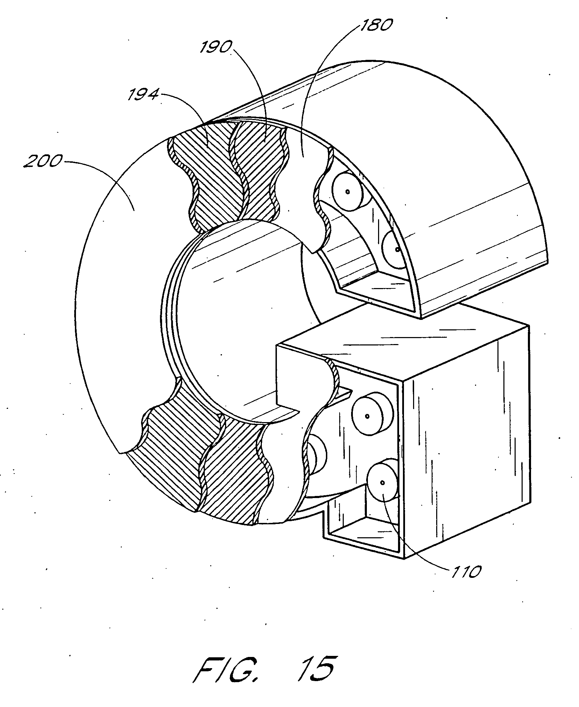

The cylindrical or semi-cylindrical devices illustrated in FIGURES 1-4 may be used in a number of different applications, such as for decorative illumination, light boxes, backlights, and for guidance along pathways. Further, the housing utilized with the optical diverters 110 and sheet member 170 may be constructed in various sizes and shapes, including wide area planar, linear elongate, and curved elongate. FIGURE 15 illustrates one embodiment in which the letter "G" has been formed. Other possible embodiments will be apparent to those skilled in the art. For example, instead of positioning the optical diverters 110 along a line or a curve, the optical diverters may be mounted, for example, in a grid (not shown) to cover a wide-area display, the surface of which may have numbers, letters, logos, or other indicia printed thereon.

## Claims

1. An illumination apparatus, comprising:
- a cavity having reflective surfaces (150) and an output area;
- at least one light source disposed in the cavity, the light source comprising a point source (174) and an optical diverter (110, 110a, 110b, 110c, 110d) having a flared reflecting surface; and
- an optical conditioning element (210) over the output area, the optical conditioning element (210) comprising at least a diffuser (180), **characterized in that** the optical diverter (110, 110a, 110b, 110c) extends about an axis (424) that is substantially aligned with and passes through the light source (174);
**in that** the flared reflecting surface (410, 410b) extends between an apex portion (421) of the surface and a base portion (450, 450c) of the surface; **in that** the axis (424) passes through the apex portion (421) and the point source (174);
and **in that** the base portion (450, 450c) is above the apex portion (421) and extends radially outwardly from the axis (424) such that the reflecting surface (410, 410b) flares outwardly from the apex portion (421) to the base portion (450, 450c).

2. The apparatus according to claim 1,
wherein the flared surface (410) is curved.

3. The apparatus according to claim 1 or 2,
wherein the flared surface (410b) is cuspated.

4. The apparatus according to any of claims 1 to 3,
wherein the flared surface (410) is formed by a refractive index interface configured to totally internally reflect light from the point source (174) laterally outwardly from the axis (424).

5. The apparatus according to any of claims 1 to 4,
wherein the point source (174) comprises an LED.

6. The apparatus according to any of claims 1 to 4,
wherein the point source (174) comprises a miniature incandescent filament or arc lamp.

7. The apparatus according to any of claims 1 to 6,
wherein the optical conditioning element (210) comprises a prism sheet (190).

8. The apparatus according to claim 7,
additionally comprising a second prism sheet (194), each prism sheet (190, 194) having repeated structures oriented generally orthogonal to repeated structures of the other prism sheet (190, 194).

9. The apparatus according to claim 7,
wherein the prism sheet (190) and the diffuser (180) are in substantially parallel relationship, with the diffuser (180) being closer to the light source (174) than the prism sheet (190).

10. The apparatus according to any of claims 1 to 9,
wherein the cavity is within an elongated housing (140, 240) having a width which is not substantially greater than the width of the output area.

11. The apparatus according to claim 10,
wherein the optical conditioning element (210) comprises at least one prism sheet (190) having repeated structures oriented at about 45° relative to a longitudinal axis of the elongated housing (140).

12. The apparatus according to claim 10 or 11,
wherein the apparatus (100, 230) comprises at least two of the elongated housings (140, 240) coupled end to end.

13. The apparatus according to any of claims 1 to 12,
wherein the point source (174) and the optical conditioning element (210) are separated by 3.5 inches or less.

14. The apparatus according to any of claims 1 to 12,
wherein the point source (174) and the optical conditioning element (210) are separated by 2.5 inches or less.

15. The apparatus according to any of claims 1 to 12,
wherein the point source (174) and the optical conditioning element (210) are separated by 1.5 inches or less.

16. The apparatus according to any of claims 1 to 15,
wherein the cavity reflecting surfaces (150) are diffusively reflective.

17. The apparatus according to claim 16,
wherein the diffusively reflective surfaces (150) have a reflectivity of at least 90%.

18. The apparatus according to any of claims 1 to 17,
wherein the flared reflecting surface (410) is partially reflective and partially transmissive.

19. The apparatus according to any of claims 1 to 16,
wherein the flared reflecting surface (410) is configured to totally internally reflect light.

20. The apparatus according to any of claims 1 to 19,
wherein the at least one light source as a point source (174) is spaced less than 3.5 inches from the sheet (150) and illuminates the reflective surfaces (150) such that the ratio of the luminance of adjacent pixels is between 0.95 and 1.05 and the ratio of the luminance of non-adjacent pixels is between 0.5 and 2.0, whereby the appearance of illumination at the sheet (150) is substantially uniform.

21. The apparatus according to any of claims 1 to 20,
wherein the optical diverter (110, 110a) is comprised of transparent material having a reflecting surface (410) formed by a refractive index interface configured to totally internally reflect light from the point source (174) positioned to emit a first portion of light rays (470) towards the reflecting surface (410) and a second portion of light rays (460) towards a side surface (120) of the diverter (110, 110a), the diverter (110, 110a) comprising a refracting interface (480) that refracts the second portion of light rays (460) towards the reflecting surface (410), such that both the first and second portions of light rays (470) are reflected from the reflecting surface (410).

22. The apparatus according to claim 21,
wherein the point source (174) emits a third portion of light rays (465) towards the side surface, the diverter (110, 110a) further comprising a scattering surface (490) that scatters the third portion of rays (465).

23. The apparatus according to claim 21,
wherein the point source (174) is disposed at the bottom of the diverter (110, 110a), and the reflecting surface (410) is oriented to reflect the first and second portions of light rays (460, 470) towards the bottom of the diverter (110, 110a).

24. The apparatus according to any of claims 1 to 23,
wherein the diverter (110c) is positioned between the point source (174) and the optical conditioning element (210) such that
(a) a portion of light emitted by the point source (174) is reflected from the diverter (110c) towards the reflective surfaces (150) of the cavity, and
(b) another portion of light emitted by the point source (174) is transmitted through the surface of the diverter (110c) towards the optical conditioning element (210),
wherein the diverter (110c) is sized to allow at least a substantial portion of the reflected light to reach the optical conditioning element (210) without passing through the diverter (110c), and wherein the diverter (110c) and the reflective surfaces (150) of the cavity are arranged to allow at least a substantial portion of the transmitted light to reach the optical conditioning element (210) without undergoing reflection.

## Patentansprüche

1. Beleuchtungsvorrichtung, die folgendes aufweist:
- einen Hohlraum, der Reflexionsoberflächen (150) und einen Ausgangsbereich besitzt;
- mindestens eine Lichtquelle, die in dem Hohlraum angeordnet ist, wobei die Lichtquelle eine Punktquelle (174) und eine optische Ablenkeinrichtung (110, 110a, 110b, 110c, 110d) hat, die eine konisch erweiterte reflektierende Oberfläche hat; und
- ein optisches Konditionierungselement (210) über dem Ausgangsbereich,
wobei das optische Konditionierungselement (210) mindestens einen Diffusor (180) aufweist,
**dadurch gekennzeichnet,**
**daß** sich das optische Ablenkelement (110, 110a, 110b, 110c) um eine Achse (424) erstreckt, die mit der Lichtquelle (174) im wesentlichen ausgefluchtet ist und durch diese hindurchgeht;
**daß** sich die konisch erweiterte reflektierende Oberfläche (410, 410b) zwischen einem Scheitelbereich (421) der Oberfläche und einem Basisbereich (450, 450c) der Oberfläche erstreckt;
**daß** die Achse (424) durch den Scheitelbereich (421) und die Punktquelle (174) hindurchgeht;
und **daß** der Basisbereich (450, 450c) oberhalb von dem Scheitelbereich (421) liegt und sich von der Achse (424) radial nach außen erstreckt, so daß sich die reflektierende Oberfläche (410, 410b) von dem Scheitelbereich (421) zu dem Basisbereich (450, 450c) nach außen konisch erweitert.

2. Vorrichtung nach Anspruch 1,
wobei die konisch erweiterte Oberfläche (410) gekrümmt ist.

3. Vorrichtung nach Anspruch 1 oder 2,
wobei die konisch erweiterte Oberfläche (410b) eine Cusp-Form besitzt.

4. Vorrichtung nach einem der Ansprüche 1 bis 3,
wobei die konisch erweiterte Oberfläche (410) von einer Brechungsgrenzfläche gebildet ist, die für eine innere Totalreflexion von Licht von der Punktquelle (174) von der Achse (424) seitlich nach außen konfiguriert ist.

5. Vorrichtung nach einem der Ansprüche 1 bis 4,
wobei die Punktquelle (174) eine LED aufweist.

6. Vorrichtung nach einem der Ansprüche 1 bis 4,
wobei die Punktquelle (174) einen Miniaturglühfaden oder eine Bogenlampe aufweist.

7. Vorrichtung nach einem der Ansprüche 1 bis 6,
wobei das optische Konditionierungselement (210) einen Prismenflächenkörper (190) aufweist.

8. Vorrichtung nach Anspruch 7,
die zusätzlich einen zweiten Prismenflächenkörper (194) aufweist, wobei jeder Prismenflächenkörper (190, 194) sich wiederholende Strukturen hat, die im allgemeinen orthogonal zu sich wiederholenden Strukturen des anderen Prismenflächenkörpers (190, 194) orientiert sind.

9. Vorrichtung nach Anspruch 7,
wobei der Prismenflächenkörper (190) und der Diffusor (180) in einer im wesentlichen parallelen Relation zueinander stehen, wobei der Diffusor (180) der Lichtquelle (174) näher ist als der Prismenflächenkörper (190).

10. Vorrichtung nach einem der Ansprüche 1 bis 9,
wobei der Hohlraum innerhalb eines langgestreckten Gehäuses (140, 240) ist, das eine Breite hat, die nicht wesentlich größer als die Breite des Ausgangsbereichs ist.

11. Vorrichtung nach Anspruch 10,
wobei das optische Konditionierungselement (210) mindestens einen Prismenflächenkörper (190) aufweist, der sich wiederholende Strukturen hat, die unter einem Winkel von 45° relativ zu einer Längsachse des langgestreckten Gehäuses (140) orientiert sind.

12. Vorrichtung nach Anspruch 10 oder 11,
wobei die Vorrichtung (100, 230) mindestens zwei von den langgestreckten Gehäusen (140, 240) aufweist, die mit den Enden aneinander gekoppelt sind.

13. Vorrichtung nach einem der Ansprüche 1 bis 12,
wobei die Punktquelle (174) und das optische Konditionierungselement (210) um 3,5 inch oder weniger voneinander getrennt sind.

14. Vorrichtung nach einem der Ansprüche 1 bis 12,
wobei die Punktquelle (174) und das optische Konditionierungselement (210) um 2,5 inch oder weniger voneinander getrennt sind.

15. Vorrichtung nach einem der Ansprüche 1 bis 12,
wobei die Punktquelle (174) und das optische Konditionierungselement (210) um 1,5 inch oder weniger voneinander getrennt sind.

16. Vorrichtung nach einem der Ansprüche 1 bis 15,
wobei die reflektierenden Oberflächen (150) des Hohlraums diffus reflektierend sind.

17. Vorrichtung nach Anspruch 16,
wobei die diffus reflektierenden Oberflächen (150) ein Reflexionsvermögen von mindestens 90 % haben.

18. Vorrichtung nach einem der Ansprüche 1 bis 17,
wobei die konisch erweiterte reflektierende Oberfläche (410) teilweise reflektierend und teilweise durchlässig ist.

19. Vorrichtung nach einem der Ansprüche 1 bis 16,
wobei die konisch erweiterte reflektierende Oberfläche (410) für eine innere Totalreflexion von Licht konfiguriert ist.

20. Vorrichtung nach einem der Ansprüche 1 bis 19,
wobei die mindestens eine Lichtquelle als eine Punktquelle (174) weniger als 3,5 inch von dem Flächenkörper (150) beabstandet ist und die Reflexionsoberflächen (150) so beleuchtet, daß das Verhältnis der Leuchtdichte von benachbarten Pixeln zwischen 0,95 und 1,05 liegt und das Verhältnis der Leuchtdichte von nicht benachbarten Pixeln zwischen 0,5 und 2,0 liegt, so daß das Erscheinungsbild der Beleuchtung an dem Flächenkörper (150) im wesentlichen gleichmäßig ist.

21. Vorrichtung nach einem der Ansprüche 1 bis 20,
wobei die optische Umlenkeinrichtung (110, 110a) aus einem transparenten Material besteht, das eine reflektierende Oberfläche (410) hat, die von einer Brechungsgrenzfläche gebildet ist, die für eine innere Totalreflexion von Licht von der Punktquelle (174) konfiguriert ist, die so positioniert ist, daß sie einen ersten Anteil von Lichtstrahlen (470) zu der reflektierenden Oberfläche (410) hin abstrahlt und einen zweiten Anteil von Lichtstrahlen (460) zu einer seitlichen Oberfläche (120) der Ablenkeinrichtung (110, 110a) hin abstrahlt, wobei die Ablenkeinrichtung (110, 110a) eine Brechungsgrenzfläche (480) aufweist, die den zweiten Anteil von Lichtstrahlen (460) zu der reflektierenden Oberfläche (410) hin bricht, so daß sowohl der erste als auch der zweite Anteil von Lichtstrahlen (470) von der reflektierenden Oberfläche (410) reflektiert werden.

22. Vorrichtung nach Anspruch 21,
wobei die Punktquelle (174) einen dritten Anteil von Lichtstrahlen (465) zu der seitlichen Oberfläche hin abstrahlt, wobei die Ablenkeinrichtung (110, 110a) ferner eine Streufläche (490) aufweist, die den dritten Anteil von Strahlen (465) streut.

23. Vorrichtung nach Anspruch 21,
wobei die Punktquelle (174) am Boden der Ablenkeinrichtung (110, 110a) angeordnet ist und wobei die reflektierende Oberfläche (410) so orientiert ist, daß sie den ersten und den zweiten Anteil von Lichtstrahlen (460, 470) zu dem Boden der Ablenkeinrichtung (110, 110a) hin reflektiert.

24. Vorrichtung nach einem der Ansprüche 1 bis 23,
wobei die Ablenkeinrichtung (110c) zwischen der Punktquelle (174) und dem optischen Konditionierungselement (210) so positioniert ist, daß
(a) ein Anteil von Licht, das von der Punktquelle (174) abgestrahlt wird, von der Ablenkeinrichtung (110c) zu den Reflexionsoberflächen (150) des Hohlraums hin reflektiert wird, und
(b) ein anderer Anteil von Licht, das von der Punktquelle (174) abgestrahlt wird, durch die Oberfläche der Ablenkeinrichtung (110c) zu dem optischen Konditionierungselement (210) hin durchgelassen wird,
wobei die Ablenkeinrichtung (110c) so dimensioniert ist, daß sie es ermöglicht, daß zumindest ein erheblicher Anteil des reflektierten Lichts das optische Konditionierungselement (210) erreicht, ohne durch die Ablenkeinrichtung (110c) hindurchzugehen,
und wobei die Ablenkeinrichtung (110c) und die Reflexionsoberflächen (150) des Hohlraums so angeordnet sind, daß sie es ermöglichen, daß zumindest ein erheblicher Anteil des durchgelassenen Lichts das optische Konditionierungselement (210) erreicht, ohne eine Reflexion zu erfahren.

## Revendications

1. Appareil d'éclairage, comprenant:
- une cavité ayant des surfaces réfléchissantes (150) et une région de sortie;
- au moins une source de lumière disposée dans la cavité, la source de lumière comprenant une source ponctuelle (174) et un répartiteur optique (110, 110a, 110b, 110c, 110d) ayant une surface réfléchissante évasée; et
- un élément de conditionnement optique (210) sur la région de sortie, l'élément de conditionnement optique (210) comprenant au moins un diffuseur (180),
**caractérisé en ce que** le répartiteur optique (110, 110a, 110b, 110c) s'étend autour d'un axe (424) qui est sensiblement aligné avec la source de lumière (174) et qui passe par celle-ci;
**en ce que** la surface réfléchissante évasée (410, 410b) s'étend entre une partie en pointe (421) de la surface et une partie de base (450, 450c) de la surface; **en ce que** l'axe (424) passe par la partie en pointe (421) et la source ponctuelle (174);
et **en ce que** la partie de base (450, 450c) est au-dessus de la partie en pointe (421) et s'étend radialement vers l'extérieur par rapport à l'axe (424) de sorte que la surface réfléchissante (410, 410b) s'évase de l'extérieur de la partie en pointe (421) vers la partie de base (450, 450c).

2. Appareil selon la revendication 1,
dans lequel la surface évasée (410) est incurvée.

3. Appareil selon la revendication 1 ou 2,
dans lequel la surface évasée (410b) est cuspidée.

4. Appareil selon l'une quelconque des revendications 1 à 3,
dans lequel la surface évasée (410) est formée par une interface à indice de réfraction configurée pour réfléchir totalement vers l'intérieur la lumière provenant de la source ponctuelle (174) latéralement vers l'extérieur par rapport à l'axe (424).

5. Appareil selon l'une quelconque des revendications 1 à 4,
dans lequel la source ponctuelle (174) comprend une DEL.

6. Appareil selon l'une quelconque des revendications 1 à 4,
dans lequel la source ponctuelle (174) comprend une lampe miniature à incandescence ou à arc.

7. Appareil selon l'une quelconque des revendications 1 à 6,
dans lequel l'élément de conditionnement optique (210) comprend une feuille prismatique (190).

8. Appareil selon la revendication 7,
comprenant en plus une deuxième feuille prismatique (194), chaque feuille prismatique (190, 194) comportant des structures répétées orientées généralement orthogonalement aux structures répétées de l'autre feuille prismatique (190, 194).

9. Appareil selon la revendication 7,
dans lequel la feuille prismatique (190) et le diffuseur (180) sont dans une relation sensiblement parallèle, le diffuseur (180) étant plus proche de la source de lumière (174) que la feuille prismatique (190).

10. Appareil selon l'une quelconque des revendications 1 à 9,
dans lequel la cavité est dans un logement allongé (140, 240) dont la largeur n'est pas sensiblement plus grande que la largeur de la région de sortie.

11. Appareil selon la revendication 10,
dans lequel l'élément de conditionnement optique (210) comprend au moins une feuille prismatique (190) comportant des structures répétées orientées à environ 45° par rapport à un axe longitudinal du logement allongé (140).

12. Appareil selon la revendication 10 ou 11,
dans lequel l'appareil (100, 230) comprend au moins deux des logements allongés (140, 240) accouplés bout à bout.

13. Appareil selon l'une quelconque des revendications 1 à 12,
dans lequel la source ponctuelle (174) et l'élément de conditionnement optique (210) sont séparés de 3,5 pouces ou moins.

14. Appareil selon l'une quelconque des revendications 1 à 12,
dans lequel la source ponctuelle (174) et l'élément de conditionnement optique (210) sont séparés de 2,5 pouces ou moins.

15. Appareil selon l'une quelconque des revendications 1 à 12,
dans lequel la source ponctuelle (174) et l'élément de conditionnement optique (210) sont séparés de 1,5 pouces ou moins.

16. Appareil selon l'une quelconque des revendications 1 à 15,
dans lequel les surfaces réfléchissantes (150) de la cavité sont réfléchissantes de manière diffuse.

17. Appareil selon la revendication 16,
dans lequel les surfaces réfléchissantes de manière diffuse (150) ont une réflectivité d'au moins 90 %.

18. Appareil selon l'une quelconque des revendications 1 à 17,
dans lequel la surface réfléchissante évasée (410) est partiellement réfléchissante et partiellement transmissive.

19. Appareil selon l'une quelconque des revendications 1 à 16,
dans lequel la surface réfléchissante évasée (410) est configurée pour réfléchir la lumière totalement vers l'intérieur.

20. Appareil selon l'une quelconque des revendications 1 à 19,
dans lequel ladite au moins une source de lumière en tant que source ponctuelle (174) est espacée de moins de 3,5 pouces de la feuille (150) et éclaire les surfaces réfléchissantes (150) de sorte que le rapport de la luminance de pixels adjacents soit entre 0,95 et 1,05 et que le rapport de la luminance de pixels non adjacents soit entre 0,5 et 2,0, de sorte que l'apparence de l'éclairage au niveau de la feuille (150) est sensiblement uniforme.

21. Appareil selon l'une quelconque des revendications 1 à 20,
dans lequel le répartiteur optique (110, 110a) est constitué d'un matériau transparent ayant une surface réfléchissante (410) formée par une interface à indice de réfraction configurée pour réfléchir totalement vers l'intérieur la lumière provenant de la source ponctuelle (174) positionnée pour émettre une première partie de rayons lumineux (470) vers la surface réfléchissante (410) et une deuxième partie de rayons lumineux (460) vers une surface latérale (120) du répartiteur (110, 110a), le répartiteur (110, 110a) comprenant une interface de réfraction (480) qui réfracte la deuxième partie de rayons lumineux (460) vers la surface réfléchissante (410), de sorte qu'à la fois les première et deuxième parties de rayons lumineux (470) soient réfléchies par la surface réfléchissante (410).

22. Appareil selon la revendication 21,
dans lequel la source ponctuelle (174) émet une troisième partie de rayons lumineux (465) vers la surface latérale, le répartiteur (110, 110a) comprenant en outre une surface de diffusion (490) qui diffuse la troisième partie de rayons (465).

23. Appareil selon la revendication 21,
dans lequel la source ponctuelle (174) est disposée au fond du répartiteur (110, 110a), et la surface réfléchissante (410) est orientée de manière à réfléchir les première et deuxième parties de rayons lumineux (460, 470) vers le fond du répartiteur (110, 110a).

24. Appareil selon l'une quelconque des revendications 1 à 23,
dans lequel le répartiteur (110c) est positionné entre la source ponctuelle (174) et l'élément de conditionnement optique (210) de sorte que
(a) une partie de la lumière émise par la source ponctuelle (174) soit réfléchie du répartiteur (110c) vers les surfaces réfléchissantes (150) de la cavité, et
(b) une autre partie de la lumière émise par la source ponctuelle (174) soit transmise à travers la surface du répartiteur (110c) vers l'élément de conditionnement optique (210),
dans lequel le répartiteur (110c) est dimensionné de manière à permettre à au moins une grande partie de la lumière réfléchie d'atteindre l'élément de conditionnement optique (210) sans passer à travers le répartiteur (110c), et
dans lequel le répartiteur (110c) et les surfaces réfléchissantes (150) de la cavité sont agencés de manière à permettre à au moins une grande partie de la lumière transmise d'atteindre l'élément de conditionnement optique (210) sans subir de réflexion.
